# EUROPEAN PATENT APPLICATION

(11) **EP 4 811 040 A1**
(43) Date of publication of application: **23.09.2026**
(21) Application number: 25165070.1
(22) Date of filing: 20.03.2025
(51) Int. Cl.: G03F 7/105, G03F 7/20, C09B 23/01, C09B 23/08, C09B 67/22

(54) **RELIEF FORMING PRINTING PLATES**

(71) Applicant: ECO3 BV, 2640 Mortsel (BE)
(72) Inventor: ARAUJO, Adelaide, 2640 Mortsel (BE); BILLIET, Thomas, 2640 Mortsel (BE); LICHA, Kai, 06766 Bitterfeld-Wolfen (DE)
(74) Representative: De Clercq & Partners

(57) **Abstract**

A mask forming film is disclosed comprising a carrier sheet, optionally an intermediate layer, and an imageable layer including at least one infrared absorbing dye according to Formula I 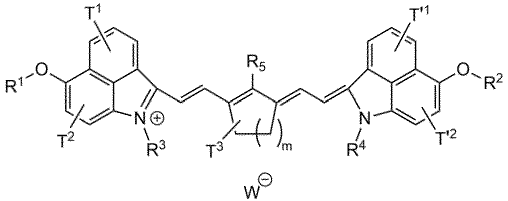 wherein
R¹ and R² independently represent a methyl, ethyl, propyl or butyl group;
T¹, T², T³, T⁴, T^{'1} and T^{'2} independently represent hydrogen, a halogen, an optionally substituted alkyl group, a cyano, methoxy, ethoxy, propoxy or butoxy group;
R³ and R⁴ independently represent an optionally substituted alkyl group;
m represents 1 or 2, and
W represents an anion which renders the chromophoric group neutral.

## Description

### Technical Field

The present invention relates to a mask forming film including a novel infrared absorbing dye, which is suitable for preparing relief printing plates. The present invention further relates to methods for the preparation of relief printing elements using the mask forming film.

### Background Art

Relief printing plates are plates having image areas raised above open areas. Generally, the plate is somewhat soft, and flexible enough to wrap around a printing cylinder, and durable enough to print many copies. Flexography is commonly used for high-volume runs and employed for printing on a variety of substrates such as paper, paperboard, corrugated board, films, foils and laminates. Especially for printing on coarse surfaces and stretch films, flexography is of interest.

Many methods for making relief images are known in the graphic arts. Photosensitive materials comprising an ablatable or mask layer on the surface of a photosensitive layer, a so-called "integral mask" or "in-situ mask" or "integrated mask" may be used for preparing a relief image without the use of a photographic negative or separate masking elements. These photosensitive materials are formed into relief images by first image-wise exposing the photosensitive material with laser radiation to selectively remove the layer in the exposed areas, i.e. forming a mask, followed by overall exposure with actinic radiation to cure the photosensitive layer in the unmasked areas. The remaining areas of the mask layer and the non-hardened portions of the photosensitive layer are then removed preferably by one or more liquid development processes. Examples of photosensitive relief-forming precursors including an integral mask are for example described in for example EP 3 047 336 and EP 3 304 203.

The resulting surface, after development, has a relief pattern that reproduces the image to be printed and which typically includes both solid areas and patterned areas comprising a plurality of relief dots. After the relief image is developed, the relief printing element may be mounted on a printing press and printing commenced.

Alternative methods include making an article bearing a relief image by first forming a mask image on a base material, for example by thermally imaging a suitable mask film or masking element to provide the desired pattern (generally using an infrared radiation laser under computer control), followed by transferring the mask image to a photosensitive material, and exposing the photosensitive material to a curing radiation, typically ultraviolet radiation.

In the latter method, a mask may be formed by exposing a mask layer provided on a base material to laser radiation, generally infrared radiation.

In the imaging process of the methods described above, the exposed regions may be removed by for example laser ablation. The ablation of the mask layer may be performed by means of various lasers. Preferably, lasers which emit light in the near IR wavelength range are used. They include for example, IR laser diodes (830 nm) or Nd-YAG solid-state lasers or fiber lasers (1064 or 1100 nm, respectively). In order to obtain effective ablation of the mask layer, efficient absorption of the laser beam is crucial. Therefore, often infrared absorbers such as finely dispersed carbon black or IR-absorbing dyes are used in the mask layer. The base material of the mask film is preferably transparent for UV light, such as for example transparent polyester films. The imaged mask film is subsequently placed onto a photosensitive material for overall exposure with actinic radiation, e.g. UV radiation, to cure the photosensitive material in the unmasked areas, thus forming a negative image of the mask element in the photosensitive relief-forming precursor.

The mask film and the photosensitive material are brought into intimate contact by for example using a laminator device or vacuum drawdown, or both, and subjected to overall exposure with actinic radiation (for example, UV radiation) to cure the photosensitive composition of the relief-forming precursor in the unmasked areas.

Air and/or void space trapped between the mask film and the photosensitive material should be avoided in order to obtain optical contact bonding between both. If optical contact bonding is not achieved, the light used in the exposure step may scatter due to the space and/or trapped air resulting in a relief image that is not an exact representation of the intended image on the film mask.

Alternative methods to provide optical contact bonding between the mask film and the photosensitive material have been proposed in the art. For example, by using an imaged film that adheres to the photosensitive material during the curing step, so that the vacuum draw-down step is not needed. Also, vacuum has been successfully replaced in the art by application of pressure or elevated temperature to laminate the mask film onto the photosensitive material.

The assembly of the imaged mask film and the photosensitive material is subsequently imaged with UVA. The exposed regions of the photosensitive material harden or cure and become insoluble in developing liquids while the unexposed regions remain soluble. The cured portions define the printing areas and remain on the printing plate. The mask element can then be removed and the remaining areas of the mask layer and the non-hardened portions of the photosensitive material are preferably washed away by one or more liquid development processes, for example aqueous or solvent processing. After drying, the resulting relief printing plate has a relief image that can be used for example in flexographic or letterpress printing operations.

EP 1 146 392 discloses a method for making a relief image by laminating an ablatable mask layer to a UV-sensitive material with the use of an adhesive layer to create an integral mask on the UV-sensitive material before the imaging/curing step.

EP 1 735 664 discloses a method including the steps of forming a transferable mask on a carrier sheet including an imageable layer, and transferring the mask image to a photosensitive material that is sensitive to UV curing radiation, such that the imageable material adheres more to the photosensitive material than to the carrier sheet.

EP 1 883 858 discloses a method of making a relief image comprising the steps of laminating an imaged film to a heated imageable article comprising a releasing layer disposed on a photosensitive material, followed by exposing the imageable article without vacuum draw-down to curing radiation through the imaged film. The subsequently removed image film from the imageable article is reusable.

EP 2 987 030 discloses an imageable material consisting essentially of a transparent polymeric carrier sheet, a barrier layer comprising a first infrared radiation absorbing compound, wherein the carrier sheet and/or barrier layer comprise a first ultraviolet radiation absorbing compound, and a non-silver halide thermally sensitive imageable layer comprising a second infrared radiation absorbing compound and a second ultraviolet radiation absorbing compound.

EP 2 153 278 discloses a method for making a relief image comprising the steps of laminating onto a heat-sensitive element, a mask including a film comprising an imageable layer on a transparent carrier sheet which includes a transparent layer which has a refractive index lower than the carrier sheet or lower than any optional layers between the carrier sheet and the transparent layer.

EP 3 323 017 discloses a laser-ablatable mask film for exposing relief printing plates comprising (i) a dimensionally stable base sheet (ii) a UV-transparent adhesion layer and (iii) a laser-ablatable mask layer comprising a crosslinked polyvinyl alcohol and a material which absorbs UV/VIS light and IR light such as carbon black.

EP 3 752 885 discloses an imageable material including a transparent carrier sheet; a non-ablatable light-to-heat converting layer comprising an infrared absorber, a crosslinked binder and non-thermally ablatable particles; and a thermally ablatable imaging layer comprising a second infrared absorber and a UV-light absorber dispersed in a thermally-ablatable polymeric binder.

In the art, there is an ongoing need to further improve the quality of relief-forming printing plate precursors. More specific, there is a need for improving the ablation efficiency of the mask forming layer whereby efficient absorption of the laser beam is crucial.

### Summary of invention

It is an object of the present invention to provide an improved heat-sensitive, ablatable mask forming film including a heat-sensitive, mask forming ablatable layer; characterized by not only a high IR sensitivity and a high UV optical density but also a low rest UV optical density, i.e. the UV optical density after ablation in the ablated areas.

The mask forming film includes an infrared absorbing dye as defined in independent claim 1. The infrared absorbing dye preferably has a structure according to Formula I: 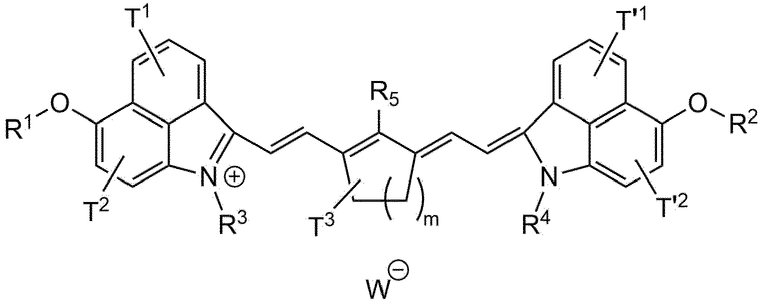 wherein
R₅ represents an optionally substituted aryl group or an optionally substituted heteroaryl group;
R¹ and R² independently represent a methyl, ethyl, propyl or butyl group;
T¹**,** T², T³, T^{'1} and T^{'2} independently represent hydrogen, a halogen, cyano, a methoxy, ethoxy, propoxy or butoxy group, or an optionally substituted alkyl group;
R³ and R⁴ independently represent an optionally substituted alkyl group;
m represents 1 or 2, and
W⁻ represents an anion which renders the chromophoric group neutral.

It was surprisingly found that, after ablation of the mask forming film according to the present invention whereby a mask image is formed, the ablated areas (mask image) are highly transparent for UV light; i.e. they have an UV optical density preferably below 0.2. The optical density can be measured using a suitable filter on a densitometer. This object has been achieved by the mask forming film according to claims 1 to 8 including at least one infrared absorbing dye as defined in claim 1.

It is a further object of the present invention to provide methods for making a relief-forming printing plate precursor including the mask forming film according to the present invention. The methods for making a relief-forming printing plate precursor comprise the steps of image-wise exposing the mask forming film whereby a mask image is formed - before or after providing the mask forming film to the relief-forming printing plate precursor. The imaged relief-forming printing plate precursor including the mask image is subsequently exposed to curing radiation and developed whereby a relief-forming printing plate is formed.

It was further found that the exposure step with actinic light to induce polymerization of the relief forming layer through the mask, is more efficient - i.e. requiring shorter exposure times and/or lower energy light. As a result, plate making is improved in terms of both productivity and ecology.

Other features, elements, steps, characteristics and advantages of the present invention will become more apparent from the following detailed description of preferred embodiments of the present invention. Specific embodiments of the invention are also defined in the dependent claims.

### Description of embodiments

### Definitions:

The "imageable film", "film" or "mask forming film" described herein refers to "a mask element", "mask(ing) film", or "masking element". Upon imaging, the film contains a "mask image" and may be known as a "mask", "imaged film", or "imaged masking film".

The term "relief-forming (printing plate) precursor" as used herein refers to any imageable, photosensitive material in which a relief image can be produced by exposure through the imaged mask forming film. The photosensitive material includes a photopolymerizable layer also referred to as a photocurable layer. Examples of such relief-forming precursors include for example flexographic printing plate precursors, letterpress printing plate precursors, and printed circuit boards.

The term "relief printing element" or "relief printing plate" refers to an element including a relief image such as a flexographic printing plate, a letterpress printing plate and printed circuit boards.

The term "ablative" means that the imageable layer of the mask forming film can be imaged using a thermal ablating means such as laser radiation that causes rapid local changes in the imageable layer thereby causing the material(s) in the imageable layer to be ejected from the layer. This is distinguishable from other material transfer or imaging techniques in that a chemical change (for example, melting, evaporation, or sublimation) rather than a physical change is the predominant mechanism of imaging.

The term "hardened" means that the coating becomes insoluble or non-dispersible in the developing solution and may be achieved through polymerization and/or crosslinking of the photosensitive coating.

"Optical contact" means that two layers or two elements (for example the imaged mask forming film and the photosensitive material) are in intimate contact so that there is essentially no air-gap or void between the contacted surfaces, thus providing an "air-free interface".

The use of numerical values in the various ranges specified herein, are considered to be approximations as though the minimum and maximum values within the stated ranges are preceded by the word "about." In this manner, slight variations above and below the stated ranges may be useful to achieve substantially the same results as the values within the ranges. In addition, the disclosure of these ranges is intended as a continuous range including every value between the minimum and maximum values as well as the end points of the ranges.

On site preparation refers to the performance by the end-user of the whole process: i.e. image-wise exposing, (de)laminating, flood exposing and developing.

Unless otherwise noted, the term "transparent" used herein refers to the ability of a material or layer to transmit at least 95% of incident electromagnetic radiation, preferably at least 98% of incident light, such as electromagnetic radiation having a wavelength of at least 200 nm to and including 750 nm (generally known as respectively UV and visible radiation).

### Infrared absorbing dye

The infrared absorbing compound, also referred to herein as IR-absorbing dye or IR-dye, preferably absorbs infrared (IR) radiation light and converts the absorbed energy into heat. The IR-dye preferably includes a conjugated system having its main absorption, more preferably its absorption maximum, in the infrared region, i.e. radiation preferably having a wavelength in the range from 750 to 1500 nm, more preferably in the range from 750 nm to 1250 nm, most preferably in the range from 750 nm to 1100 nm. The infrared absorbing dye used in the current invention preferably has a strong maximum absorption in the range from 900 nm to 1200 nm, more preferably in the range from 950 to 1100 nm and preferably a second absorption peak in the range of 750 to 1000 nm. The IR light absorbing dye used in the present invention more preferably absorbs light at different wavelengths, i.e. at about 830 nm and at about 1064 nm.

The infrared absorbing dye used in the present invention preferably has a structure according to Formula I: 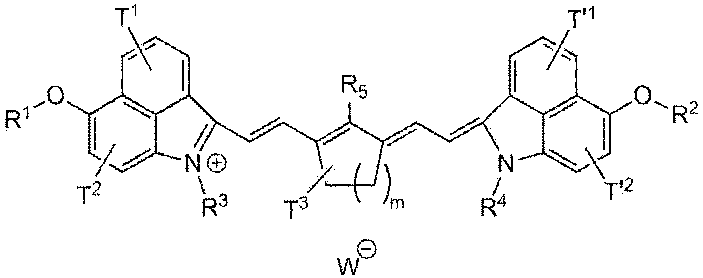 wherein
R₅ represents an optionally substituted aryl group or an optionally substituted heteroaryl group;
R¹ and R² independently represent a methyl, ethyl, propyl or butyl group;
T¹**,** T², T³, T^{'1} and T^{'2} independently represent hydrogen, a halogen, an optionally substituted alkyl group, a cyano, methoxy, ethoxy, propoxy or butoxy group;
R³ and R⁴ independently represent an optionally substituted alkyl group;
m represents 1 or 2, and
W⁻ represents an anion which renders the chromophoric group neutral.

The infrared absorbing dye used in the present invention more preferably has a structure according to Formula II: 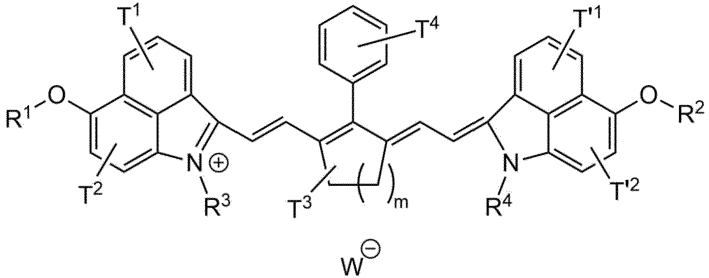 wherein
R¹ and R² independently represent a methyl, ethyl, propyl or butyl group;
T¹**,** T², T³, T⁴, T^{'1} and T^{'2} independently represent hydrogen, a halogen, an optionally substituted alkyl group, a cyano, methoxy, ethoxy, propoxy or butoxy group;
R³ and R⁴ independently represent an optionally substituted alkyl group;
m represents 1 or 2, and
W⁻ represents an anion which renders the chromophoric group neutral.

The infrared absorbing dye used in the present invention even more preferably has a structure according to Formula III 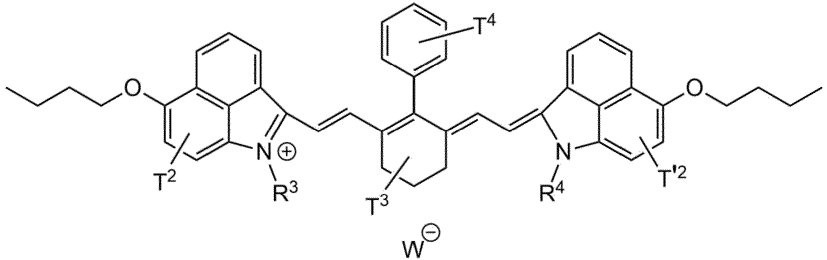 wherein
T², T³, T⁴ and T^{'2} independently represent hydrogen, a halogen, an optionally substituted alkyl group, a cyano, methoxy, ethoxy, propoxy or butoxy group;
R³ and R⁴ independently represent an optionally substituted alkyl group; and
W⁻ represents an anion which renders the chromophoric group neutral.

The infrared absorbing dye used in the present invention most preferably has a structure according to Formula IV: 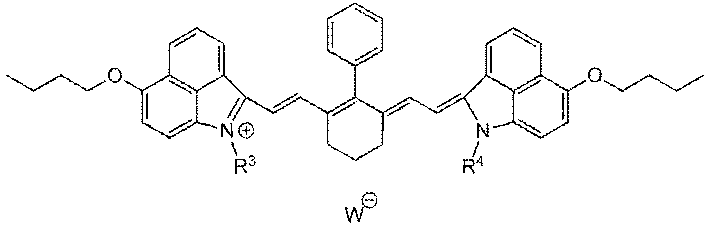 wherein
R³ and R⁴ independently represent an optionally substituted alkyl group; and
W⁻ represents an anion which renders the chromophoric group neutral.

Most preferably the infrared absorbing dye has the following structure, Formula V: 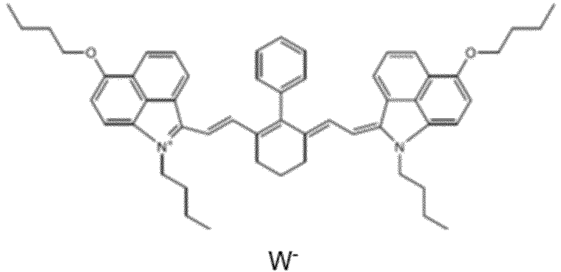 wherein W⁻ represents an anion which renders the chromophoric group neutral.

The counterion W⁻ in the Formulae described above, preferably represents a halide anion, e.g. Cl⁻, Br⁻ or I⁻, a sulfonate group anion such as an alkyl or aryl sulfonate group anion; e.g. CH₃SO₃⁻, CF₃S0₃⁻ or p-toluene sulfonate; bis(trifluoromethansulfonyl)imide (NTf₂₋); tetrafluoroborate; hexafluorophosphate or a perfluoroalkyl containing group; the perfluoroalkyl group preferably includes at least 5 fluorine atoms. The perfluoroalkyl group is most preferred and may be represented by CF₃-(CF₂)ₘ-(CH₂)ₙ-G wherein m and n independently represent 0 or an integer greater than 0, and G represents for example -SO₃⁻, -HPO₃⁻, -HPO₄⁻ or -COO⁻. Most preferably G represents -SO₃⁻ or -COO⁻, m = 0, 1, 2 or 3 and n = 0, 1, 2 or 3.

Examples of suitable aryl groups may be represented by for example an optionally substituted phenyl, benzyl, tolyl or an ortho- meta- or para-xylyl group, an optionally substituted naphtyl, anthracenyl, phenanthrenyl, and/or combinations thereof. Unless otherwise defined, the heteroaryl group herein is preferably a monocyclic or polycyclic aromatic ring comprising carbon atoms and one or more heteroatoms in the ring structure, preferably, 1 to 4 heteroatoms, independently selected from nitrogen, oxygen, selenium and sulphur. Preferred examples thereof include an optionally substituted furyl, pyridinyl, pyrimidyl, pyrazoyl, imidazoyl, oxazoyl, isoxazoyl, thienyl, tetrazoyl, thiazoyl, (1,2,3)triazoyl, (1,2,4)triazoyl, thiadiazoyl, thiofenyl group and/or combinations thereof.

Examples of suitable alkyl groups are methyl, ethyl, n-propyl, isopropyl, n-butyl, 1-isobutyl, 2-isobutyl and tertiary-butyl, n-pentyl, n-hexyl, chloromethyl, trichloromethyl, iso-propyl, iso-butyl, iso-pentyl, neo-pentyl, 1-methylbutyl and iso-hexyl, 1,1-dimethyl-propyl, 2,2-dimethylpropyl and 2-methyl-butyl, cyclopropyl, cyclobutyl, cyclopentyl, cyclohexyl and methylcyclohexyl groups. n-butyl, etc.

A suitable alkenyl group is preferably a C₂ to C₆ alkenyl group such as an ethenyl, n-propenyl, n-butenyl, n-pentenyl, n-hexenyl, iso-propenyl, isobutenyl, iso-pentenyl, neo-pentenyl, 1-methylbutenyl, iso-hexenyl, cyclopentenyl, cyclohexenyl and methylcyclohexenyl group.

A suitable alkynyl group is preferably a C₂ to C₆ alkynyl group; a suitable aralkyl group is preferably a phenyl group or naphthyl group including one, two, three or more C₁ to C₆ alkyl groups; a suitable alkaryl group is preferably a C₁ to C₆ alkyl group including an aryl group, preferably a phenyl group or naphthyl group.

A cyclic group or cyclic structure includes at least one ring structure and may be a monocyclic- or polycyclic group, meaning one or more rings fused together.

The term "substituted", in e.g. substituted alkyl group means that the alkyl group may contain groups other atoms than the atoms normally present in such a group, i.e. carbon and hydrogen. For example, a substituted alkyl group may include a halogen atom or a thiol group. It also means that a carbon atom may be replaced by another atom, such as for example oxygen, sulfur or nitrogen, thereby interrupting the alkyl chain with a heteroatom. For example, substitution of a carbon atom in the alkyl chain by oxygen would constitute an ether bond as substitution. An unsubstituted alkyl group contains only carbon and hydrogen atoms.

The optional substituents on the alkyl, cycloalkyl, alkenyl, cycloalkenyl, alkynyl, aralkyl, alkaryl, aryl, heteroaryl and heterocyclic group are preferably selected from hydroxy, -Cl, -Br, -I, -OH, -SH, -CN, -NO₂, an alkyl group such as a methyl or ethyl group, an alkoxy group such as a methoxy or an ethoxy group, an aryloxy group, a carboxylic acid group or an alkyl ester thereof, a sulphonic acid group or an alkyl ester thereof, a phosphonic acid group or an alkyl ester thereof, a phosphoric acid group or an ester such as an alkyl ester such as methyl ester or ethyl ester, a thioalkyl group, a thioaryl group, thioheteroaryl, -SH, a thioether such as a thioalkyl or thioaryl, ketone, aldehyde, sulfoxide, sulfone, sulfonate ester, sulphonamide, an amino, ethenyl, alkenyl, alkynyl, cycloalkyl, alkaryl, aralkyl, aryl, heteroaryl or heteroalicyclic group and/or combinations thereof.

### Relief-forming precursor

Relief-forming precursors typically contain a UV sensitive layer on a dimensionally stable support or also referred to as substrate. Preferably, the relief-forming precursor is a flexographic printing plate precursor, a letterpress printing plate precursor or a printed circuit board. Most preferably the relief-forming precursor is a flexographic printing plate precursor. The UV sensitive layer is also referred to herein as photopolymerizable layer, photocurable layer or relief-image forming layer.

Suitable supports include dimensionally stable polymeric films and aluminum sheets. Polyester films are particularly useful. Optionally the support may be coated with additional layers e.g. an adhesion improving layer.

The support is typically about 20 - 200 microns thick. Optionally, the support may be pretreated in order to modify its wettability and/or adhesion behaviour to subsequently applied coatings. Such surface treatments include corona discharge treatment, application of an intermediate layer such as a subbing layer, a release layer and/or an adhesive layer such as an acrylic or vinyl acetate adhesive.

The relief-forming precursor can be positive or negative-working, but is typically negative-working and preferably includes a photopolymerizable layer, also referred to herein as a photocurable layer. The photopolymerizable layer preferably comprises an elastomeric binder and a UV curable composition that can be cured or hardened by mainly polymerization and/or crosslinking upon exposure to UV radiation. The UV curable composition preferably comprises polymerizable or photocurable monomer(s) and at least one photoinitiator.

Suitable polymerizable monomers include ethylenically unsaturated polymerizable compounds having relatively low molecular weight (generally less than 30,000 Daltons) such as for example polymerizable monomers including various mono- and polyacrylates, acrylate derivatives of isocyanates, esters, and epoxides. Specific suitable monomers include, but are not limited to t-butyl acrylate, lauryl acrylate, the acrylate and methacrylate mono- and polyesters of alcohols and polyols such as alkanols, e. g. , 1, 4-butanediol diacrylate, 2, 2, 4-trimethyl-1, 3 pentanediol dimethacrylate, and 2, 2-dimethylolpropane diacrylate, alkylene glycols, e. g. , tripropylene glycol diacrylate, butylene glycol dimethacrylate, hexamethylene glycol diacrylate, and hexamethylene glycol dimethacrylate, trimethylol propane, ethoxylated trimethylol propane, pentaerythritol, e. g. , pentaerythritol triacrylate, dipentaerythritol, and the like. Other examples of suitable monomers include acrylate and methacrylate derivatives of isocyanates, esters, epoxides and the like, such as decamethylene glycol diacrylate, 2, 2-di(phydroxyphenyl)propane diacrylate, 2, 2-di(p-hydroxyphenyl)propane dimethacrylate, polyoxyethyl-2, 2-di(p-hydroxyphenyl)propane dimethacrylate, and 1-phenyl ethylene-1, 2-dimethacrylate. The typical amount of one or more polymerizable monomers in the UV-sensitive layer is at least 5 weight % and up to and including 25 weight %, based on total dry weight of the UV-sensitive layer.

The photoinitiator can be a single compound or combination of compounds that are sensitive to UV radiation and that generate free radicals that initiate the polymerization of the polymerizable monomer(s) without excessive termination. They are preferably present in an amount of about 0.001 weight % and up to and including 10 weight % based on the total dry weight of the UV sensitive layer. Examples of suitable photoinitiators include but are not limited to optionally substituted polynuclear quinones, vicinal ketaldonyl alcohols, alphahydrocarbon-substituted aromatic acyloins, dyes of the phenazine, oxazine, and quinone classes and cyclohexadienone compounds.

The elastomeric binder preferably comprises polymers or resins that are preferably soluble, swellable or dispersible in aqueous, semi-aqueous, or organic solvent developers. Suitable examples include, but are not limited to, natural or synthetic polymers of conjugated diolefin hydrocarbons including polyisoprene, 1, 2-polybutadiene, 1, 4-polybutadiene, butadiene/acrylonitrile, block copolymers such as for example butadiene/styrene thermoplastic-elastomeric block copolymers, coreshell microgels, and blends of microgels and preformed macromolecular polymers. The elastomeric binder can comprise at least 65 weight % and up to and including 90 weight %, based on total dry UV-sensitive layer weight.

The UV-sensitive layer may include other compounds that provide various properties including but not limited to sensitizers, plasticizers, rheology modifiers, thermal polymerization inhibitors, tackifiers, colorants, antioxidants, anti-ozonants, and fillers; in amounts that are known in the art. Examples of suitable plasticizers include aliphatic hydrocarbon oils, e. g. naphthenic and paraffinic oils, liquid polydienes such as liquid polybutadiene, liquid polyisoprene. Generally, plasticizers are liquids having molecular weights of less than about 5.000 Daltons but can have molecular weights up to about 30.000 Daltons.

The thickness of the UV-sensitive layer is preferably at least 500 µm and up to and including 6400 µm in average dry thickness.

The relief-forming precursor may be protected against mechanical damage by for example a removable protective or cover film or sheet located on the uppermost layer. The cover sheet should be removed before placing the mask forming film in proximity of the relief-forming precursor. Useful cover sheets include flexible polymeric films, e.g., polystyrene, polyethylene, polypropylene, polycarbonate, fluoropolymers, polyamide or polyesters. Preferably polyesters are used, especially polyethylene terephthalate.

### Mask forming film

Preferably, a mask forming film is used to form a mask image. The mask forming film including the novel IR light absorbing dye preferably comprises at least one imageable layer as described below, and a carrier sheet. The imageable layer is generally disposed on the carrier sheet as a relatively uniform coating of one or more layers. Preferably, the film includes one imageable layer. The film may optionally further include one or more additional layers, such as for example a barrier layer.

Alternatively, the imageable layer may be coated on the UV sensitive layer of the relief-forming precursor.

### Carrier sheet

The carrier sheet of the mask forming film may be any suitable substrate. Suitable substrates include, for example, plastic sheets and films, such as polyethylene terephthalate or polyethylene naphthalate, fluorene polyester polymers, polyethylene, polypropylene, polybutadienes, polyacrylates, polycarbonates, polyvinyl chloride and copolymers thereof, and hydrolyzed and non-hydrolyzed cellulose acetate. The carrier sheet should preferably be sufficiently transparent to the imaging radiation and is preferably a transparent polymeric film. A preferred carrier sheet is a polyethylene terephthalate sheet and is about 20 µm to about 200 µm thick. The carrier sheet may be treated e.g. corona discharge treatment, or include an intermediate layer such as for example an adhesion promoter layer, a release layer, a subbing layer, a scratch resistant (hardcoat) layer and/or a hardened gelatin layer. Preferably, the carrier sheet is an untreated or unsubbed plastic film or sheet, i.e. a plastic film or sheet which has not been treated with any of such (transparent) coating layers.

### The imageable layer

The imageable layer is preferably a laser ablatable layer and includes a heat combustible polymeric binder and at least one IR light absorbing dye according to the present invention as described above, which sensitizes the imageable layer to imaging IR radiation.

The IR light absorbing dye is preferably present in an amount of about 1 to 30 %wt, more preferably in an amount of 10 to 25 %wt, and most preferably in an amount between 15 and 20 %wt based on the dry content of the imageable layer.

The heat-combustible polymeric binder can optionally be present in an optional other layer. The heat-combustible polymeric binder can be decomposed, depolymerized or evaporated without a preceding melting step by the heat generated by the IR light absorbing compound upon laser exposure. Binders that are easily thermally combustible and generate gases and volatile fragments at temperatures below about 200 °C are preferred. The heat-combustible polymeric binder preferably comprises nitro groups or nitrate ester groups. Especially nitrate esters of cellulose or cellulose derivatives such as cellulose ethers, methyl cellulose, ethyl cellulose, nitro-cellulose, 2-hydroxyethyl cellulose, 2-hydroxypropyl cellulose, carboxy-methyl cellulose, cellulose ethers, polycarbonates, polyurethanes, polyesters, polyorthoesters, polyacetals, and copolymers thereof are preferred binders. Further examples of heat-combustible binders include poly (glycidyl azide), poly (glycidyl nitrate) or poly (vinyilnitrate), nitro derivatives of polystyrene such as polymers comprising nitro-, dinitro- or trinitro-styrene groups; polyacrylates or polymethacrylates such as polymers comprising 2,4-dinitrophenyl acrylate or p-nitrophenylacrylate as monomers; and/or combinations thereof.

In general, the heat-combustible polymeric binder is present for about 5 - 80%wt, preferably 8-60%wt and more preferably 10 - 40%wt based on the total amount of the ingredients in the imageable layer.

The imageable layer may further include a polysiloxane compound. The polysiloxane compound preferably comprises siloxane units which may be a linear, branched, cyclic or complex cross-linked polymer or copolymer. The term polysiloxane compound includes any compound which contains more than one siloxane group -Si(R,R')-O-, wherein R and R' are optionally substituted alkyl or aryl groups. Preferred siloxanes are phenylalkylsiloxanes and dialkylsiloxanes, e.g. phenylmethylsiloxanes and dimethylsiloxanes. The number of siloxane groups -Si(R,R')-O- in the (co)polymer is at least 2, preferably at least 10, more preferably at least 20. It may be less than 100, preferably less than 60. The polysiloxane compound further preferably includes an alkylene-oxide block preferably including units of the formula -CnH₂ₙ-O- wherein n is preferably an integer in the range 2 to 5. The moiety - CnH₂ₙ- may include straight or branched chains. The alkylene-oxide block moiety may also comprise optional substituents. A suitable polysiloxane compound is preferably a random or block-copolymer comprising siloxane and alkyleneoxide groups, suitably comprising about 15 to 25 siloxane units and 50 to 70 alkyleneoxide groups. Preferred polysiloxanes include a copolymer of dimethyldichlorosilane, ethylene oxide and propylene oxide. Specific compounds are the following: 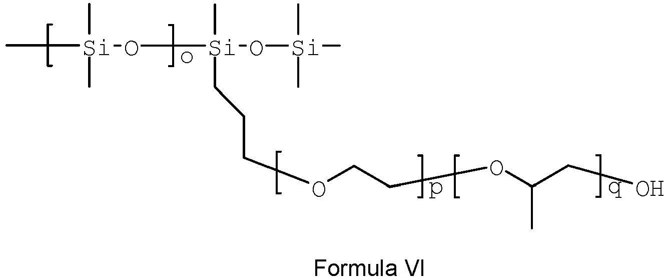 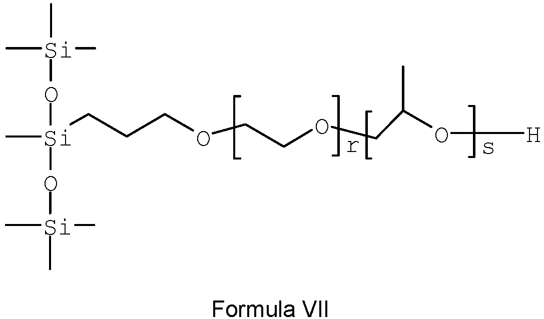 wherein o, p, q, r and s are integers >1

In Formula VI, a poly(alkylene oxide) block consisting of ethylene oxide and propylene oxide units is grafted to a polysiloxane block. In Formula VII, long chain alcohols consisting of ethylene oxide and propylene oxide units are grafted to a trisiloxane group.

The polysiloxane compound is preferably present in the imageable layer in an amount between 0.01 to 1.5%wt, more preferably between 0.04 to 1.0%wt and most preferably between 0.1%wt to 0.5%wt.

Optionally, the image forming layer may include at least one further IR light absorbing dye which can absorb at about 830 nm, or preferably at about 1064 nm, or at both about 830 nm and about 1064 nm, such as for example phthalocyanine dyes such as phtalocyanine blue, cyanine dyes, triarylmethane dyes, merocyanine dyes and polymethine dyes and/or derivatives thereof; metals such as aluminum or inorganic pigments such as carbon black, graphite, iron oxide or chromium oxide. Carbon black - e.g. fine-grained carbon black with a mean particle size below 30 nm - renders, in addition to IR light, the ablatable layer also opaque to UV radiation.

The image forming layer preferably includes one or more UV absorbers capable of strong absorbance and/or blocking of the curing radiation, for example by reflectance. The UV absorber substantially prevents the transmission of curing radiation through the mask image. Suitable examples of UV absorbers for use in the imageable material include mixtures of dyes and/or pigments dispersed within a polymeric binder(s) with or without the aid of a dispersant. Pigments may be preferred because they do not tend to migrate. The use of pigment dispersions in imaging is well-known in the art, and any conventional pigments useful for that purpose may be used in the present invention. It is particularly preferred that the pigments or dyes are non-IR absorbing so that imaging of the radiation-sensitive imageable layer is not adversely affected.

The UV optical density of the mask forming film is preferably 2 or more, more preferably 3 or more. The optical density can be measured using a suitable filter on a densitometer.

The UV absorber preferably absorbs radiation of about 150 to 450 nm. The UV absorber may additionally absorb visible radiation, for example from 350 to 750 nm.

The UV absorber(s) may be present in the imageable layer in an amount from about 10 to 50 weight %, and preferably in an amount from about 10 to 40 weight % based on the dry content of the imageable layer.

Suitable examples of UV absorbers include black dyes and/or pigments such as carbon black, metal particles and metal oxides. It may be desirable to use a carbon black having small particles for maximum color strength. Fine-grained carbon black brands with a mean particle size below 30 nm are especially suitable. The carbon black may comprise, for example, about 10-50 wt %, more particularly about 10-40 wt %, and even more particularly about 10-30 wt % of the total weight of the imageable layer.

Specific preferred UV absorbers include benzotriazoles, halogenated benzotriazoles, high molecular weight benzotriazoles, triazines, curcumines, benzophenones, benzoates, titanium or zinc oxides, campher, avobenzone, imidazoles, p-aminobenzoic acid, salicylates, substituted acrylonitriles, cyanoacrylates, benzilidene malonates, oxalanilides, UV absorbers commercially available from ADEKA such as for example ADK STAB LA-24, LA-29, LA-31R(G), LA-32, LA 36 (RG), LA-46, 1413 and mixtures thereof.

The imageable layer preferably includes at least one polymeric binder or resin. Binders or resins having hydroxyl groups such as for example poly(vinyl alcohol)s and cellulosic polymers, non-crosslinkable polyesters, polyamides, polycarbamates, polyolefins, polystyrenes, polyethers, polyvinyl ethers, polyvinyl esters, and polyacrylates and poly(meth)acrylates, terpene resins, phenolic resins, aromatic hydrocarbon resins, polyurethanes, long-chain acrylate and methacrylate resins, adhesive binders such as poly(vinyl butyral)s and phenolic resins are useful. Preferably, these polymeric binders are soluble in suitable coating solvents such as lower alcohols, ketones, ethers, hydrocarbons, and halogeno alkanes, and also preferably soluble or swellable in the developer solution.

Adhesive binders such as thermally adhesive binders having a glass transition temperature (Tg) of less than about 65 °C such as acetyl polymers and acrylamide polymers or pressure-sensitive adhesive binders are of particular interest.

The polymeric binder(s) are preferably present in an amount of from 25 to 75 weight % and more preferably in an amount from 35 to 65 weight %, based on the total dry weight of the imageable layer.

Optional other ingredients of the imageable layer include but are not limited to plasticizers, coating aids, surfactants, adhesion promotors, colorants, dispersing agents such as for example polyester/polyamine copolymers, alkyl aryl polyether alcohols and acrylic binders, contrast agents, wetting agents and fillers. These components are preferably dispersed in one or more polymeric binders that are capable of dissolving or dispersing the components in the imageable layer.

The components of the imageable layer are preferably soluble or swellable in suitable developers including both chlorinated organic solvents and non-chlorinated organic solvents - as described below.

The imageable layer is preferably provided on the carrier sheet as a continuous, uniform coating. Preferably, one imageable layer is present on the carrier sheet but optionally more than one imageable layer may be present on the carrier sheet

### Optional other layers

The mask forming film may optionally includes other layers on top of the imageable layer such as an overcoat layer selected from (i) a protective layer i.e. a thin layer transparent to UV-light which limits oxygen diffusion, e.g. including polyvinylalcohol, cellulose and derivatives, or polyamide and/or (ii) a barrier layer, preferably a non-transparent barrier layer. The protective layer and/or barrier layer may act as a dye barrier layer to prevent dye migration from the imageable layer to the photocurable layer after merging (e.g. lamination) of both layers (see below). The barrier layer preferably includes polyvinylalcohol and/or a polysiloxane compound as described above. These optional layers preferably do not significantly absorb or scatter the curing radiation, for example, they preferably do not include matte agents or other light scattering materials and are preferably relatively thin and preferably have a dry thickness of about 0.05 to 1 µm.

### Image-wise exposure

The mask forming film as described above can be laminated (see below) onto the relief forming layer of the relief-forming printing plate precursor followed by image-wise exposure, or can be first image-wise irradiated and then be laminated onto the relief forming layer of the relief forming printing plate precursor.

Preferred devices used for image-wise exposure are Nd/YAG lasers (1064 nm) or diode lasers (e.g. 830 nm). In the current invention, Nd/YAG lasers (1064 nm) are preferred. Following exposure to radiation and removal of the exposed portions of the imageable layer, the remaining imageable layer is referred to as the mask image.

The generation of heat in the imageable layer may then result in a physical or chemical change of the components of the imageable layer, or most preferably induce ablation. In the ablative mode of imaging the energy provided by the laser expels the imageable layer at the spot where the laser beam hits the mask forming film. A debris collector, such as, for example, a vacuum or a suitable receptor sheet, may be placed near the imageable layer to retrieve the exposed imageable layer after it is propelled from the carrier sheet.

Preferably, the exposed areas of the imageable layer are removed through ablation. The imageable layer including the combustible binders as described above, may be propelled from the carrier sheet by generation of a gas. The build-up of gas under or within the exposed areas of the imageable layer creates pressure that propels the imageable layer of the carrier sheet in the exposed areas. This action is distinguishable from other mass transfer techniques in that a chemical change (e. g. bond-breaking) rather than a physical change (e.g. melting, evaporation or sublimation) causes an almost complete transfer of the imageable layer.

### Lamination

In a first preferred embodiment, the mask forming film is provided - preferably laminated - onto the UV-sensitive layer of a suitable relief - forming precursor prior to the image-wise exposure step. Alternatively, the heat-sensitive ablatable layer as described above may be coated onto the UV-sensitive layer of a suitable relief-forming precursor prior to image-wise exposure as described above. Prior to the image-wise exposure step, the carrier sheet (including optional intermediate layers) of the mask forming film is preferably removed.

In a second preferred embodiment, the mask forming film is provided - preferably laminated - onto the UV-sensitive layer of a relief-forming precursor after the image-wise exposure step.

The mask forming film and relief-forming precursor are preferably placed in complete optical contact so as to provide an air-free interface at the shared interface. Optionally, an anti-tack layer (or separation, or spacer layer) may be used. This is typically achieved in the art by laminating the mask forming film to the UV-sensitive layer of the relief-forming precursor by applying suitable pressure or heat, or both pressure and heat to form an air-free or gap-free interface prior to UV exposure. This is preferably achieved by means of a laminator device. An optional cover sheet is preferably removed before lamination. The relief-image forming assembly of the mask forming film and the relief-forming precursor can be fed into a laminator at a desired speed, temperature, and pressure. In the art, often a vacuum table is used to apply a balanced, non-distorting optimized lamination force to the relief forming precursor and the mask forming film to achieve optical contact while minimizing lateral distortion.

Useful lamination (laminator) devices and methods for using them are known in the art.

### UV exposure

Subsequently, the relief-forming precursor including the mask image - formed by laminating an image-wise exposed mask forming film or by laminating the mask forming film prior to image-wise exposure - is subjected to flood exposure with UV-light using suitable irradiation sources of UV radiation through the mask image. This causes the areas of the UV-sensitive layer which are not covered by the mask image (i.e. the imageable layer) to become insoluble in a developer (negative working UV-sensitive materials) e.g. by photopolymerization or photocrosslinking) or to solubilise in a developer (positive working UV-sensitive materials). The mask image information is thus transferred to the relief-forming precursor.

Exposure can be carried out in the presence of atmospheric oxygen as the relief forming precursor and the mask image are preferably in complete optical contact.

In the manufacture of the relief-forming precursor, one side of the relief-forming precursor is preferably exposed to curing UV radiation through its transparent substrate (known as "back exposure") to prepare a thin, uniform cured layer material (i.e. a floor) on the substrate side of the UV-sensitive layer. This floor provides an improved adhesion between the photopolymerizable layer and the support, helps to improve resolution and establishes the depth of the plate relief. The backside exposure can be performed before, during or after the imaging step. Preferably the backside exposure is carried out just before the UV exposure step discussed above.

The mask image is substantially opaque to the exposing or curing UV radiation, meaning that the mask image should preferably have a UV transmission optical density of 2 or more, and typically 3. The unmasked regions should be substantially transparent meaning that they should preferably have a UV transmission optical density of 0.5 or less, or even 0.2 or less. Transmission optical density can be measured using a suitable filter on a densitometer.

In the preferred negative-working embodiment, the unexposed and thus uncured regions of the UV-sensitive layer can then be removed by a developing process (described below), leaving the cured or hardened regions that define the relief image including a predetermined pattern of shapes and sizes including peaks and valleys.

The wavelength or range of wavelengths suitable as the curing UV radiation is related to the electromagnetic sensitivity of the relief-forming precursor. Preferably, the UV curing radiation can have one or more wavelengths in the range of at least 150 nm and up to and including 450 nm, or more typically of at least 300 nm and up to and including 450 nm.

Suitable sources of UV radiation for floodwise or overall exposure include but are not limited to, carbon arcs, mercury-vapor arcs, fluorescent lamps, electron flash units, and photographic flood lamps. UV radiation is particularly useful from mercury-vapor lamps, light emitting diode(s) (LED) emitting UV radiation, and sun lamps.

The time for exposure through the mask image will depend upon the nature and thickness of the UV sensitive layer of the relief-forming precursor and the source and strength of the UV radiation. For example, about a few seconds to several minutes may be required to prepare a thin, uniform cured layer on the support side of the relief forming precursor. The relief image forming assembly of mask image and relief-forming precursor can then be exposed to UV radiation through the mask image for for example about 10 to 20 minutes.

### Delamination

In the second preferred embodiment where the mask forming film is provided onto the UV-sensitive layer of a relief-forming precursor after the image-wise exposure step, the assembly of the imaged relief-forming precursor and the mask are preferably delaminated after the UV-exposure step and before development (see below). This can be done in various ways, e.g. manually peeling the two elements apart by for example pulling the carrier sheet including the mask away from the imaged relief-forming precursor, and/or in an automated way. Preferably, the carrier sheet including optional intermediate layers and the mask is removed whereby the obtained film is reusable.

### Development

The obtained imaged relief-forming precursors are then preferably developed with a suitable developer (or processing solution, or washout solution) to form the relief image. During development, in the preferred negative-working embodiment, the non-exposed (uncured) regions of the UV-sensitive layer, optional other layers and/or remaining imageable layer are preferably removed, leaving the exposed (cured) regions that define the relief image.

As a developer, aqueous liquids, organic solvents and/or solvent mixtures may be used; most preferably, an aqueous developer is used. Any known solvent-based or aqueous-based developer can be used, including non-chlorinated and/or chlorinated developers. For example, developers containing organic solvents such mixtures of aliphatic hydrocarbons and long chain alcohols, e.g. alcohols with at least 7 carbon atoms, perchloroethylene solvents, diethylene glycol dialkyl ethers, acetic acid esters or alcohols, carboxylic acid esters, and esters of alkoxy substituted carboxylic acids. diisopropylbenzene (DIPB), methyl esters, dipropylene glycol dimethyl ether (DME), aliphatic dibasic acid ethers, alkali metal salt of (un)saturated fatty acid having a carbon number of 12 to 18 and including mono- or poly-unsaturated fatty acids or alkali metal salts thereof; amino polycarboxylic acid or alkali metal salt thereof, and/or combinations thereof.

Development can be carried out under known conditions such as for at least 1 minute and up to and including 20 minutes and at a temperature of up to and including 50°C. The type of developing apparatus and specific developer that are used will dictate the specific development conditions and can be adapted by a skilled worker in the art.

### Post development treatments

Following the development, the obtained relief image may be dried to remove any excess solvent, for example, the relief image can be blotted or wiped dry, or dried in a forced air or infrared oven, for example during 1-4 hours at 45 °C- 65 °C for solvent developed plates and for example 10 min for water developed plates. Optimal drying times and temperatures can be defined by the person skilled in the art.

The imaged relief-forming precursor may be post-cured by exposing the relief image to curing radiation to cause further hardening or crosslinking. Post-curing can be carried out using the same type of UV-radiation previously used to expose the relief-forming precursor through the imaged mask material or for example exposure to radiation having a wavelength not higher than 300nm.

Detackification also known as light finishing can be used if the relief image surface is tacky. Such treatments, for example, by treatment with bromide or chlorine solutions or exposure to UV or visible radiation, are well known to by the person skilled in the art.

The resulting relief image may have a maximum dry depth of at least 150 µm and up to and including 1000 µm, or typically at least 200 µm and up to and including 500 µm.

The relief images obtained according to the present invention can be suitably "inked" with any desirable composition that can then be printed onto a suitable substrate or receiver material. The obtained relief image, for example a flexographic printing plate, can suitably be used for flexographic printing of for example various packaging materials.

### EXAMPLES

### 1. Components

- Carrier sheet:: poly(ethylene terephthalate), 175µm thick
- Curcumin:: yellow dye commercially available from Matrix Fine Chemicals
- Ethyl violet:: dye commercially available from Glentham (GLS); Neorez R650; polyurethane resin commercially from Covestro;
- DISP A:: pigment dispersion of 50/50 ratio Hostaperm Blue P-BFSTM commercially available from Clariant and Disperbyk 182 commercially available from BYK Chemie GmbH
- Dynoadd F-100:: wetting agent commercially available from Dynea;
- MEK:: methyl ethyl ketone available from for example Sigma-Aldrich
- Nitrocellulose:: Nitrocellulose stabilized with 30% isopropyl alcohol available from T.N.C. Industrial Co., LTD
- Dowanol PM:: 1-methoxy-2-propanol available from for example Sigma-Aldrich
- Tego glide 410:: a polyether modified polysiloxane commercially available from Evonik Industries AG
- IR-01:: Epolight 1117, IR absorbing dye having a tetrakis amminium structure commercially available from Epolin
- IR-02:: S 2007, IR cyanine absorbing dye commercially available from FEW Chemicals GmbH (Germany) having the following structure: 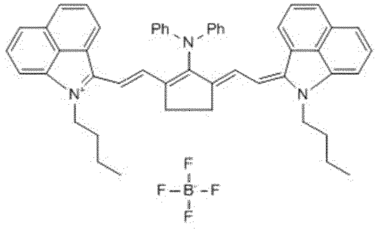
- IR-03:: S 2786, IR cyanine absorbing dye commercially available from FEW Chemicals GmbH (Germany) having the following structure: 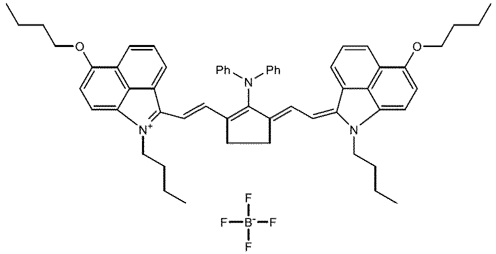
- IR-04:: Heptimel, IR absorbing dye, synthesised as described in patent application WO2022/207534 as NIR-7 pages 27-30, having the following structure: 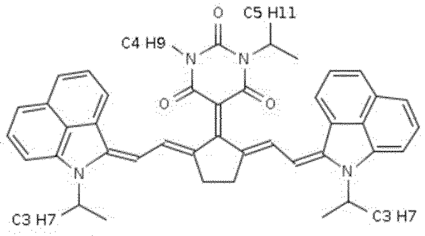
- IR-05:: S 2805, IR absorbing dye having the following structure: 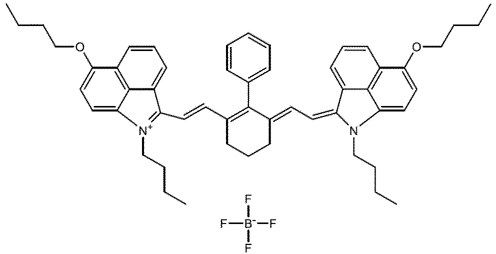 S2805 can be synthesized involving the synthesis of a benz(c,d)indolenine moiety and a polymethine bridging structural component, which are then fused to yield the desired final IR-dye structure. The benz(c,d)indolenine moiety is described e.g. by Haishima Y et al. (J. Org. Chem. 2018, 83, 4389-4401). The polymethine bridging structural component and the IR-dye can be synthesized according to Mohammed I et al. (Dyes and Pigments 99 (2013) 275-283).

### Example 1

### 1. Preparation of the comparative mask forming films Comp-01 to Comp-04 and the inventive mask forming film Inv-01

On the PET carrier sheet, a coating solution including the components shown in Table 1 dissolved in a mixture of 60% by volume of MEK and 40% by volume of Dowanol PM (1-methoxy-2-propanol, commercially available from DOW CHEMICAL Company) were coated using a wire coating rod. Subsequently, the obtained coating was dried at room temperature to form an imageable layer with a coating coverage of 1.54 g/m².

**Table 1: Composition of the imageable layers of the comparative mask forming films Comp-01 to Comp-04 and inventive mask forming film Inv-01**

| Imageable layer* | Comp-01 | Comp-02 | Comp-03 | Comp-04 | Inv-01 |
|---|---|---|---|---|---|
| | %wt (solids) | | | | |
| IR-01 | 19 | | | | |
| IR-02 | | 19 | | | |
| IR-03 | | | 19 | | |
| IR-04 | | | | 19 | |
| IR-05 | | | | | 19 |
| | | | | | |
| Curcumin | 51.0 | 51.0 | 51.0 | 51.0 | 51.0 |
| Nitrocellulose | 13.2 | 13.2 | 13.2 | 13.2 | 13.2 |
| NeoRez R650 | 6.6 | 6.6 | 6.6 | 6.6 | 6.6 |
| Dynoadd | 1 | 1 | 1 | 1 | 1 |
| DISP A | 9.0 | 9.0 | 9.0 | 9.0 | 9.0 |
| Tego glide 410 | 0.2 | 0.2 | 0.2 | 0.2 | 0.2 |

| | | | | | |
|---|---|---|---|---|---|
| *: components see above | | | | | |

### 2. Results

The cosmetic properties, optical UV density of the mask forming film and ablation sensitivity of the mask forming films were evaluated. Further, the optical UV density of the ablated areas of the obtained mask forming films was evaluated and the UV-exposure time required to expose a flexographic plate precursor through the ablated areas (the mask). The results are summarized in the Table 2 below.

### 2.1 Cosmetic properties

The coating quality (cosmetic properties) of the obtained mask forming films was visually evaluated with regards to the coating uniformity using the following qualitative scale:
1= strongly uneven coating
2= uneven coating
3= slightly uneven coating
4= nearly homogeneous coating
5= perfectly homogeneous coating

### 2.2 Optical UV density of the mask forming film

The optical UV density of the mask forming films was measured using a densitometer Gretag-MacBeth D19C densitometer, commercially available from GretagMacbeth AG. The automatic colour filter setting was used. An optical UV density below 3.5 is unacceptable. If a mask density is too low, pin holing will occur since not all light is being blocked by the mask layer.

### 2.3 Ablation sensitivity of the mask forming film

The mask forming films containing IR-01 to IR-05 were imaged on a CDI Crystal 4835^{™} available from ESKO. The amount of light was varied in a range of 0.5 to 3.0 J/cm² and 50 percent screen dot was used to define the ablation sensitivity. An ablation sensitivity of at least 0.9 J/cm² is acceptable to obtain a linear response usable to produce flexographic plates within industrial standard specifications.

### 2.4 Optical UV density (UVmin@RE) of the ablated areas of the mask forming film

The optical UV density measured with a densitometer Gretag-MacBeth D19C commercially available from GretagMacbeth AG, with automatic colour filter setting, obtained after exposure of the mask forming film at RE, was determined and should preferably be below 0.20 to ensure a contrast ratio between UVmin and UVmax that allows high latitude for the main exposure setting of the photosensitive printing plate.

The right exposure (RE) sensitivity is the energy density value (in mJ/cm²) where a 9x9 pixel 2400 dpi checkerboard pattern or the equivalent size in alternative resolutions or screening technologies reads 50-51% on the imageable mask measured with an optical measurement device such as the Spectroplate commercially available from Technkon GmbH.

### 2.5 UV exposure time

The obtained imaged films were laminated using Magis LA 370 laminator onto Magis P-ECO 1.14 flexographic printing plate precursor available from ECO3 BV and subsequently exposed with UV light.

The exposure time with UV light required to obtain a 1 to 1 pixel copy of the 9x9 pixel 2400 dpi checkerboard pattern or an equivalent at the unmasked areas of the flexographic printing plate precursor was determined. To calculate the UV exposure time, the exposure settings for the Magis P-ECO plate^{™} were used as a standard: i.e. 12 min for a UVmin of 0.20 with a 20mW/cm² light source.

**Table 2: Evaluation of inventive mask forming film Inv-01 and the comparative mask forming films Comp-01 to Comp-04**

| Imageable film | Coating quality * | Optical UV density of the imageable film * | Ablation sensitivity (J/cm²) * | UVmin @ RE * | UV exposure time (min) * |
|---|---|---|---|---|---|
| Comp-01 | 3 | > 4.0 | 1.2 | 0.33 | 16 |
| Comp-02 | 1 | > 3.8 | 1.1 | 0.30 | 15 |
| Comp-03 | 1 | < 2.0 | 2.5 | 1.40 | 190 |
| Comp-04 | 4 | > 4.0 | 1.0 | 0.27 | 14 |
| Inv-01 | 5 | >3.9 | 1.0 | 0.18 | 11 |

| | | | | | |
|---|---|---|---|---|---|
| *information see 2.1; 2.2; 2.3; 2.4 and 2.5 | | | | | |

The result in Table 2 show that
➢ the coating quality of the comparative mask forming films Comp-02 and Comp-03 is unsufficient ;
➢ the optical UV density of comparative mask forming film Comp-03 is too low;
➢ the residual UV density measured in the ablated areas (UVmin@RE) is significantly better, i.e. lower - for the inventive mask forming film Inv-01 compared to the comparative mask forming films Comp-01 to Comp-04;
➢ the exposure time with UV light through the un-masked areas required to fully polymerise the relief forming layer underneath, is significantly lower for the inventive mask forming film Inv-01. This is attributed to the higher transparency - i.e. the low UVmin@RE value - of the inventive mask forming film compared to the comparative mask forming films.

### Example 2

### 1. Preparation of the mask forming films Inv-02 to Inv-04

On the PET carrier sheet, a coating solution including the components shown in Table 3 dissolved in a mixture of 60% by volume of MEK and 40% by volume of Dowanol PM (1-methoxy-2-propanol, commercially available from DOW CHEMICAL Company) were coated using a wire coating rod. The resulting coating was dried at room temperature to form an imageable layer with a coating coverage of 1.69 to 1.78 g/m2.

**Table 3: Coating composition of the inventive mask forming films Inv-02 to Inv-04**

| Imageable layer* | Inv-02 | Inv-03 | Inv-04 |
|---|---|---|---|
| | % wt (solids) | | |
| IR-05 | 12.1 | 16.4 | 19 |
| | | | |
| Curcumin | 46.5 | 44.20 | 51.0 |
| Nitrocellulose | 24.1 | 22.9 | 13.2 |
| NeoRez R650 | 6.0 | 5.7 | 6.6 |
| Dynoadd | 0.9 | 0.8 | 1 |
| DISP A | 8.2 | 7.8 | 9.0 |
| Ethyl violet | 2 | 2 | - |
| Tego glide 410 | 0.2 | 0.2 | 0.2 |

### 2. Results

The cosmetic properties, optical UV density and ablation sensitivity of the mask forming films were evaluated. Further, the optical UV density of the ablated areas of the obtained mask forming films was evaluated and the UV-exposure time required to required to fully polymerise the relief forming layer underneath through the ablated areas (the mask). These results were obtained following the procedures described in Example 1 and are summarized in the Table 4 below. The obtained results are excellent for all three mask forming films. By lowering the IR dye concentration, the obtained results remain excellent.

**Table 4: Evaluation of the inventive mask forming films Inv-02 to Inv-04**

| Example | Coating quality | Optical UV density | Ablation sensitivity (J/cm2) | UVmin @ RE | UV exposure time (min) |
|---|---|---|---|---|---|
| Inv-02 | 5 | > 4.0 | 1.0 | 0.19 | 11 |
| Inv-03 | 5 | > 4.0 | 1.0 | 0.18 | 11 |
| Inv-04 | 5 | >3.9 | 1.0 | 0.18 | 11 |

### Example 3

### 1. Preparation of the mask forming films Comp-05 to Comp-07

On the PET carrier sheet, a coating solution was coated including the components shown in Table 5 dissolved in a mixture of 60% by volume of MEK and 40% by volume of Dowanol PM (1-methoxy-2-propanol, commercially available from DOW CHEMICAL Company) using a wire coating rod. The resulting coating was dried at room temperature to form an imageable layer with a coating coverage of 1.48 to 1.61 g/m2.

**Table 5: Coating composition of the comparative mask forming films Comp-05 to Comp-07**

| Imageable layer formulation | Comp-05 | Comp-06 | Comp-07 |
|---|---|---|---|
| | % wt solids | | |
| IR-04 | 13.2 | 18.6 | 22.7 |
| Curcumin | 53.2 | 49.8 | 48.7 |
| Nitrocellulose | 13.8 | 12.9 | 12.6 |
| NeoRez R650 | 6.9 | 6.5 | 6.3 |
| Dynoadd | 1.0 | 1.0 | 0.9 |
| DISP A | 9.4 | 8.8 | 8.6 |
| Ethyl violet | 2.3 | 2.2 | / |
| Tego glide 410 | 0.2 | 0.2 | 0.2 |

### 2. Evaluation

The cosmetic properties, optical UV density and ablation sensitivity of the imageable films were evaluated. Further, the optical UV density of the ablated areas of the obtained imageable films was evaluated and the UV-exposure time required to fully polymerise the relief forming layer underneath through the ablated areas (the mask). These results were obtained following the procedures described in Example 1 and are summarized in the Table 6 below. The results show that by increasing the IR dye concentration, the optical UV density of the ablated areas and the UV-exposure time improve but remain worse compared to the inventive Examples (Tables 2 and 4).

**Table 6: Evaluation of the comparative mask forming films Comp-05 to comp-07**

| Example | Coating quality | Ablation sensitivity (J/cm2) | Optical UV density | UVmin@RE | UV exposure time (min) |
|---|---|---|---|---|---|
| Comp-05 | 4 | 1.0 | > 4.0 | 0.38 | 18 |
| Comp-06 | 4 | 1.0 | > 4.0 | 0.24 | 13 |
| Comp-07 | 4 | 0.9 | > 3.8 | 0.25 | 13 |

## Claims

1. A mask forming film comprising
- a carrier sheet,
- optionally an intermediate layer,
- an imageable layer including at least one infrared absorbing dye according to Formula I, an UV absorber and a heat combustable binder, and
- an optional overcoat layer; 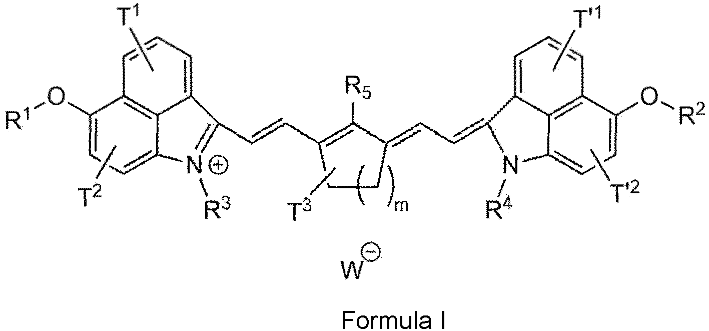 wherein
R₅ represents an optionally substituted aryl or heteroaryl group;
R¹ and R² independently represent a methyl, ethyl, propyl or butyl group; T¹**,** T², T³, T^{'1} and T^{'2} independently represent hydrogen, a halogen, cyano, a methoxy, ethoxy, propoxy or butoxy group, or an optionally substituted alkyl group;
R³ and R⁴ independently represent an optionally substituted alkyl group; m represents 1 or 2; and
W represents an anion which renders the chromophoric group neutral.

2. The film according to claim 1 wherein the at least one infrared absorbing dye has a structure according to Formula II: 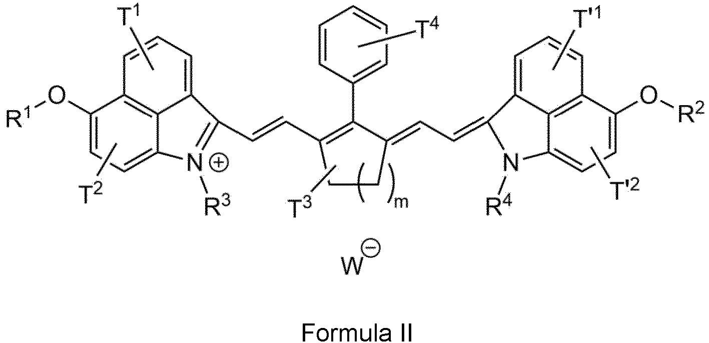 wherein
R¹ and R² independently represent a methyl, ethyl, propyl or butyl group;
T¹**,** T², T³, T⁴, T^{'1} and T^{'2} independently represent hydrogen, a halogen, an optionally substituted alkyl group, a cyano, methoxy, ethoxy, propoxy or butoxy group;
R³ and R⁴ independently represent an optionally substituted alkyl group; m represents 1 or 2, and
W represents an anion which renders the chromophoric group neutral.

3. The film according to claims 1 or 2 wherein the at least one infrared absorbing dye has a structure according to Formula IV: 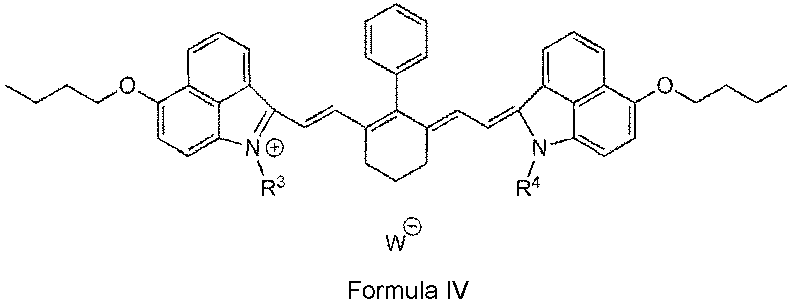 wherein
R³ and R⁴ independently represent an optionally substituted alkyl group; and
W⁻ represents an anion which renders the chromophoric group neutral.

4. The film according to claims 1 to 3 wherein the at least one infrared absorbing dye is present in an amount is 10%wt to 25 %wt relative to the total amount of the dry composition.

5. The film according to claims 1 to 4 wherein the at least one infrared absorbing dye has a maximum absorption between 950 and 1100 nm.

6. The film according to claims 1 to 5 wherein the imageable layer further includes a polysiloxane compound which comprises at least two siloxane groups -Si(R,R')-O-, wherein R and R' independently represent an optionally substituted alkyl or aryl group.

7. The film according to claim 6 wherein the polysiloxane compound is present in the imageable layer in an amount of 0.01 to 1.5%wt.

8. The film according to claims 1 to 7 wherein the carrier sheet is an untreated plastic film or sheet.

9. A relief-forming printing plate precursor having an integral mask comprising
- a substrate,
- optionally an intermediate layer,
- at least one photocurable layer including a photosensitive composition,
- an optional barrier or protective layer,
- an imageable layer as defined in claims 1 to 8.

10. The relief-forming printing plate precursor according to claim 9 wherein the relief-forming printing plate precursor comprises the barrier layer and wherein the barrier layer includes a siloxane compound which comprises at least two siloxane groups -Si(R,R')-O-, wherein R and R' independently represent an optionally substituted alkyl or aryl group.

11. A method for making a relief-forming printing plate precursor having an integral mask comprising the steps of:
- laminating the mask forming film according to claims 1 to 8 onto a relief-forming printing plate precursor including a substrate, an optional intermediate layer, and at least one photocurable layer;
- removing the carrier sheet.

12. A method for making a relief printing plate comprising the steps of:
a) Image-wise exposing the relief-forming printing plate precursor according to claim 11 whereby a mask image is formed;
b) exposing the imaged relief-forming printing plate precursor including the mask image to curing radiation;
c) developing the relief-forming printing plate precursor whereby the remaining imageable layer, the optional barrier or protective layer and the uncured areas of the photocurable layer are removed and a relief-forming printing plate is formed.

13. A method for making a relief printing plate comprising the steps of:
a) Image-wise exposing the mask forming film according to claims 1 to 8 whereby an imaged film including a mask image is formed;
b) laminating the imaged film including the mask image to a relief-forming printing plate precursor comprising a support, an optional intermediate layer, and at least one photocurable layer;
c) exposing the relief-forming printing plate precursor comprising the mask image to curing radiation;
d) removing the imaged film including the mask image from the relief-forming printing plate precursor; and
d) developing the relief-forming printing plate precursor whereby the uncured areas of the photocurable layer and optional other layers are removed and a relief-forming printing plate is formed.

14. The method according to claim 12 or 13 wherein the optical UV density of the mask image is below 0.2.

15. The method according to claims 12 to 14 wherein the relief-printing plate is a flexographic printing plate.
